# EUROPÄISCHE PATENTSCHRIFT

(11) **EP 2 193 404 B1**
(45) Veröffentlichungstag und Bekanntmachung des Hinweises auf die Patenterteilung: **23.03.2011**
(21) Anmeldenummer: 08835705.8
(22) Anmeldetag: 24.09.2008
(51) Int. Cl.: G03F 7/20

(54) **KALIBRIERUNG EINER POSITIONSMESSEINRICHTUNG EINER OPTISCHEN EINRICHTUNG**
CALIBRATION OF A POSITION-MEASURING DEVICE OF AN OPTICAL DEVICE
ÉTALONNAGE D'UN DISPOSITIF DE MESURE DE POSITION D'UN DISPOSITIF OPTIQUE

(30) Priorität: 28.09.2007 DE 102007046927
(43) Veröffentlichungstag der Anmeldung: 09.06.2010
(73) Patentinhaber: Carl Zeiss SMT GmbH, Rudolf-Eber-Strasse 2 73447 Oberkochen (DE)
(72) Erfinder: KWAN, Yim-Bun Patrick, 73431 Aalen (DE)
(74) Vertreter: Cohausz & Florack
(86) Internationale Anmeldenummer: PCT/EP2008/062787
(87) Internationale Veröffentlichungsnummer: WO 2009/043778

(56) Entgegenhaltungen:
- EP-A- 1 182 509
- WO-A-2009/014252
- DE-A1-102005 062 618
- US-A- 5 798 947
- US-A1- 2007 222 965

## Beschreibung

### HINTERGRUND DER ERFINDUNG

Die vorliegende Erfindung betrifft ein Verfahren zum Kalibrieren einer Positionsmesseinrichtung einer optischen Einrichtung. Die Erfindung lässt sich insbesondere im Zusammenhang mit der bei der Herstellung mikroelektronischer Schaltkreise verwendeten Mikrolithographie ebenso einsetzen wie im Zusammenhang mit der Inspektion von Komponenten, die bei der Herstellung solcher mikroelektronischer Schaltkreise zur Anwendung kommen (beispielsweise der Inspektion von optischen Masken), oder dem Ergebnis von Zwischenprodukten oder Endprodukten der Mikrolithographie (beispielsweise der Inspektion von belichteten Substraten). Die Erfindung betrifft daher weiterhin eine optische Einrichtung mit einer entsprechenden Positionsmesseinrichtung.

Insbesondere im Bereich der Mikrolithographie ist es neben der Verwendung mit möglichst hoher Präzision ausgeführter Komponenten unter anderem erforderlich, die Komponenten der Abbildungseinrichtung, also beispielsweise die optischen Elemente (Linsen, Spiegel etc.), die Maske mit dem abzubildenden Muster und das zu belichtende Substrat, möglichst exakt zueinander zu positionieren, um eine entsprechend hohe Abbildungsqualität zu erzielen. Die hohen Genauigkeitsanforderungen, die im mikroskopischen Bereich in der Größenordnung weniger Nanometer oder darunter liegen, sind dabei nicht zuletzt eine Folge des ständigen Bedarfs, die Auflösung der bei der Herstellung mikroelektronischer Schaltkreise verwendeten optischen Systeme zu erhöhen, um die Miniaturisierung der herzustellenden mikroelektronischen Schaltkreise voranzutreiben.

Mit der erhöhten Auflösung und der damit in der Regel einhergehenden Verringerung der Wellenlänge des verwendeten Lichts steigen nicht nur die Anforderungen an die Positioniergenauigkeit der verwendeten Komponenten. Es steigen natürlich auch die Anforderungen hinsichtlich der Minimierung der Abbildungsfehler der gesamten optischen Anordnung.

Um bei den in der Mikrolithographie verwendeten geringen Arbeitswellenlängen im UV-Bereich, beispielsweise mit Arbeitswellenlängen im Bereich von 193 nm, insbesondere aber auch im so genannten extremen UV-Bereich (EUV) mit Arbeitswellenlängen im Bereich von 13 nm, die hohen Anforderungen an die Positionierung der beteiligten Komponenten einzuhalten, wird häufig vorgeschlagen, die Position der einzelnen Komponenten, wie den Maskentisch, die optischen Elemente und den Substrattisch (z. B. einem Tisch für den so genannten Wafer), jeweils einzeln bezüglich einer Referenz - z. B. einer (hinsichtlich ihrer Position, Orientierung und Geometrie gegen dynamische und thermische Einflüsse stabilisierten) Referenzstruktur - zu erfassen und diese Komponenten dann aktiv zueinander zu positionieren.

Hierbei treten mehrere Probleme auf. Zum einen ist es in der Regel erforderlich, in bis zu sechs Freiheitsgraden eine Positioniergenauigkeit und damit auch eine Messgenauigkeit des verwendeten Messsystems im Subnanometerbereich zu erzielen. Ebenso muss das verwendete Messsystem regelmäßig kalibriert werden, um Drifterscheinungen vorzubeugen, wie sie im Betrieb einer solchen optischen Einrichtung (beispielsweise durch thermische Einflüsse oder dergleichen) auftreten können. Folglich ist es erforderlich, gegebenenfalls über mehrere Minuten bis hin zu mehreren Stunden eine hohe Positionsstabilität der Komponenten des Messsystems zu erzielen oder entsprechend häufig eine Kalibrierung durchführen. Schließlich ist es erforderlich, systematische Fehler des Messsystems (die beispielsweise durch eine Abweichung der Komponenten des Messsystems von ihrem Sollzustand bedingt sind) zu eliminieren.

Wird beispielsweise die Position einer beweglichen Einheit (wie der Substrattisch einer Mikrolithograpieeinrichtung oder dergleichen) über einen mit Planspiegeln ausgestattetes Interferometriesystem als Positionsmesseinrichtung bestimmt, so wirken sich Planaritätsabweichungen der Planspiegel (üblicherweise im Bereich von etwa 10 nm) unmittelbar auf die Messgenauigkeit und damit die Positioniergenauigkeit der beweglichen Einheit aus. Um solche systematische Fehler (typischerweise um den Faktor 20) zu reduzieren, erfolgt üblicherweise eine Kalibrierung der Positionsmesseinrichtung, wie dies beispielsweise aus der EP 1 182 509 A2 (Kwan) bekannt ist. Eine solche Kalibrierung muss in der Regel zumindest über den Zeitraum regelmäßig wiederholt werden, über den Drifterscheinungen (also beispielsweise thermisch bedingte Änderungen in der Relativposition der an der Messung beteiligten Komponenten) auftreten können.

Bei einer solchen regelmäßigen Kalibrierung werden in der Regel zwei unterschiedliche Ansätze verfolgt. Zum einen ist es bekannt, die Positionsmesseinrichtung mit einer entsprechenden Redundanz auszustatten, also für die jeweiligen Freiheitsgrade, in denen eine Positionsmessung zu erfolgen hat, mehr als eine Messeinrichtung vorzusehen, um über die hierüber zu gewinnende redundante Positionsinformation systematische Fehler zu identifizieren und zu eliminieren. Dies hat jedoch den Nachteil, dass der Aufwand für die Positionsmesseinrichtung erheblich steigt, da eine hohe Anzahl an aufwändigen und teuren hoch präzisen Messeinrichtungen erforderlich ist.

Ein weiterer Ansatz liegt in der Verwendung eines so genannten sekundären Referenzelements, welches mit der beweglichen Einheit, deren Position im Betrieb zu messen ist, dauerhaft bzw. zeitweise verbunden ist, wie dies beispielsweise aus der US 6,757,059 B2 (Ebert et al.) bzw. der US 7,160,657 B2 (Smith et al.) bekannt ist. Für die Kalibrierung der Positionsmesseinrichtung wird die Position der beweglichen Einheit zum einen über die im Betrieb genutzte erste Messeinrichtung und parallel dazu über eine zweite Messeinrichtung unter Verwendung des Referenzelements erfasst. Das in einer exakt vorgegebenen Position und Orientierung bezüglich der beweglichen Einheit befindliche Referenzelement weist dabei in der Regel eine ausreichende Anzahl von Referenzmarken (mit genau definierter Position auf den Referenzelement) auf, welche über die zweite Messeinrichtung (beispielsweise mittels einer CCD-Kamera) erfasst werden, um über eine entsprechende Verarbeitung der Messdaten der zweiten Messeinrichtung die Position und/oder Orientierung der beweglichen Einheit zu bestimmen, wie dies aus der bereits zitierten US 7,160,657 B2 (Smith et al.) bekannt ist.

Der hauptsächliche Nachteil dieser bekannten Kalibrierverfahren liegt darin, dass sie vergleichsweise langsam arbeiten, sodass die Kalibrierung insbesondere dann, wenn eine hohe Messgenauigkeit erforderlich ist und damit in der Regel eine hohe Anzahl von Referenzmarken zu erfassen ist, eine vergleichsweise lange Zeit erfordert. Typischerweise werden mehr als 30 Minuten für eine Kalibrierung benötigt, was sich beispielsweise bei der Halbleiterherstellung äußerst negativ auf den Durchsatz und damit die Produktivität der Mikrolithograpieeinrichtung auswirkt.

Ähnliche gattungsgemäße Verfahren zum Kalibrieren einer Positionsmesseinrichtung sind aus der US 5,798,947 und der EP 1 182 509 A2 bekannt. Weiterhin ist aus der US 2007/0222965 A1 ein alternatives Kalibrierverfahren anhand der Analyse von Testmustern bekannt, die auf ein Messsubstrat aufgebracht wurden. Die DE 10 2005 062 618 A1 betrifft schließlich die Bestimmung von Abbildungsfehlern eines Objektivs anhand zweidimensionaler durch das Objektiv abgebildeter Testmuster.

### KURZE ZUSAMMENFASSUNG DER ERFINDUNG

Der vorliegenden Erfindung liegt daher die Aufgabe zu Grunde, ein Verfahren zum Kalibrieren seiner Positionsmesseinrichtung einer optischen Einrichtung sowie eine entsprechende optische Einrichtung zur Verfügung zu stellen, welches bzw. welche die oben genannten Nachteile nicht oder zumindest in geringerem Maße aufweist und insbesondere auf einfache Weise möglichst in Echtzeit eine schnelle und zuverlässige Kalibrierung der Positionsmesseinrichtung ermöglicht.

Der vorliegenden Erfindung liegt die Erkenntnis zu Grunde, dass man eine schnelle und zuverlässige Kalibrierung der Positionsmesseinrichtung, gegebenenfalls sogar in Echtzeit wie im Normalbetrieb, erzielen kann, wenn als zweite Messeinrichtung ein Encodersystem verwendet wird, wobei das Referenzelement ein Referenzgitter des Encodersystems umfasst. Die Verwendung eines Encodersystems für die Messeinrichtung hat zum einen den Vorteil, dass ein solches Encodersystem in der Regel eine entsprechend hohe Verarbeitungsrate aufweist, sodass die zur Kalibrierung verwendete Referenzmessung über das Encodersystem in Echtzeit auch bei den gegebenenfalls sehr hohen Geschwindigkeiten erfolgen kann, welche die bewegliche Einheit im Normalbetrieb der optischen Einrichtung erreicht. Letztlich ist die Geschwindigkeit der Referenzmessung nur durch die Grenzen der für die Messung und die Datensammlung verwendeten Komponenten begrenzt.

Hierdurch lassen sich erheblich kürzere Unterbrechungen des Normalbetriebs der optischen Einrichtung für die Kalibrierung erzielen, sodass zum einen bei gleich bleibenden Zeitabständen zwischen den Kalibrierungen ein höherer Durchsatz bzw. eine höhere Produktivität der optischen Einrichtung erzielt werden kann. Zum anderen können die Zeitabstände zwischen den Kalibrierungen verringert werden und so durch Drifteffekte bedingte Fehler der optischen Einrichtung reduziert und somit also die Genauigkeit der optischen Einrichtung erhöht werden.

Zudem lässt sich über ein solches Encodersystem gegenüber den bekannten Verfahren eine erheblich höhere Anzahl von Messpunkten erfassen und damit eine höhere Auflösung der Positionsbestimmung im Rahmen der Referenzmessung erzielen, wodurch die Genauigkeit der Kalibrierung in einfacher Weise erheblich erhöht werden kann.

Es sind hoch präzise ein- und mehrdimensionale Encodersysteme mit einer Auflösung im Subnanometerbereich verfügbar, sodass auch anspruchsvolle Kalibrieraufgaben im Zusammenhang mit den in der Mikrolithographie verwendeten Komponenten möglich sind. Ein Beispiel für ein derartiges (zweidimensionales) Encodersystem sind die unter der Bezeichnung "Optra NanoGrid Planar Encoder" vertriebenen Encodersysteme der Firma OPTRA, Inc., Topsfield MA 01983, US, die eine Auflösung von weniger als 0,5 nm erreichen.

Ein weiterer Vorteil solcher Encodersysteme liegt darin, dass das Referenzgitter (beispielsweise über einen Belichtungsvorgang) problemlos auf ein entsprechendes thermisch stabiles Substrat (beispielsweise ein Substrat mit einem sehr geringen thermischen Ausdehnungskoeffizienten, wie z. B. Zerodur, ULE etc.) aufgebracht werden kann. Insbesondere im Zusammenhang mit den im Bereich der Mikrolithographie verwendeten Masken und zu belichtenden Substraten (z. B. Wafern) ist es möglich, das Referenzelement mit denselben Abmessungen auszuführen wie die betreffende Maske bzw. das betreffende Substrat und das Referenzelement für die Kalibrierung einfach an deren bzw. dessen Stelle auf den zugehörigen Maskentisch bzw. Substrattisch zu befestigen. Dies hat den Vorteil, dass die Referenzmessung zumindest nahe an dem im Normalbetrieb interessierenden Bereich erfolgt, für dessen Positionierung im Normalbetrieb die Messungen der zu kalibrierenden Positionsmesseinrichtung verwendet werden.

Ein Gegenstand der vorliegenden Erfindung ist daher ein Verfahren zum Kalibrieren einer Positionsmesseinrichtung einer optischen Einrichtung, bei dem in einem Messschritt eine bewegliche Einheit der optischen Einrichtung nach einem vorgebbaren Schema in wenigstens einem Freiheitsgrad bewegt wird und eine Position der beweglichen Einheit in dem wenigstens einen Freiheitsgrad erfasst wird. Die die Position der beweglichen Einheit wird in dem wenigstens einen Freiheitsgrad in einer ersten Messung über eine erste Messeinrichtung der Positionsmesseinrichtung erfasst. Weiterhin wird die Position der beweglichen Einheit in dem wenigstens einen Freiheitsgrad in einer zweiten Messung über eine zweite Messeinrichtung der Positionsmesseinrichtung unter Verwendung eines mit der beweglichen Einheit verbundenen Referenzelements erfasst. Schließlich wird in einem Kalibrierungsschritt die erste Messeinrichtung unter Verwendung der Ergebnisse der ersten Messung und der zweiten Messung kalibriert. Dabei wird als zweite Messeinrichtung ein Encodersystem verwendet, wobei das Referenzelement ein Referenzgitter des Encodersystems umfasst.

Ein weiterer Gegenstand der vorliegenden Erfindung ist eine optische Einrichtung, insbesondere für die Mikrolithographie, mit einer durch eine Antriebseinheit verfahrbaren beweglichen Einheit, einer Steuereinrichtung und einer Positionsmesseinrichtung, wobei die Positionsmesseinrichtung eine erste Messeinrichtung und eine zweite Messeinrichtung umfasst. Die Positionsmesseinrichtung ist dazu ausgebildet, in einem Messschritt eine Position der durch die Antriebseinheit nach einem vorgebbaren Schema verfahrenen beweglichen Einheit in wenigstens einem Freiheitsgrad zu erfassen. Die erste Messeinrichtung ist dazu ausgebildet, eine für die Position der beweglichen Einheit in dem wenigstens einen Freiheitsgrad repräsentative erste Variable in einer ersten Messung zu erfassen und an die Steuereinrichtung zu übergeben, während die zweite Messeinrichtung ein mit der beweglichen Einheit verbundenes Referenzelement umfasst und dazu ausgebildet ist, eine für die Position der beweglichen Einheit in dem wenigstens einen Freiheitsgrad repräsentative zweite Variable in einer zweiten Messung unter Verwendung des Referenzelements zu erfassen und an die Steuereinrichtung zu übergeben. Die Steuereinrichtung ist dazu ausgebildet, in einem Kalibrierungsschritt die erste Messeinrichtung unter Verwendung der Ergebnisse der ersten Messung und der zweiten Messung zu kalibrieren. Die zweite Messeinrichtung umfasst ein Encodersystem, wobei das Referenzelement ein Referenzgitter des Encodersystems umfasst.

Weitere bevorzugte Ausgestaltungen der Erfindung ergeben sich aus den Unteransprüchen bzw. der nachstehenden Beschreibung bevorzugter Ausführungsbeispiele, welche auf die beigefügten Zeichnungen Bezug nimmt.

### KURZE BESCHREIBUNG DER ZEICHNUNGEN

- Figur 1: ist eine schematische Darstellung einer bevorzugten Ausführungsform der erfindungsgemäßen optischen Einrichtung;
- Figur 2: ist ein Ablaufdiagramm eines Abbildungsverfahrens mit einer bevorzugten Ausführungsform des erfindungsgemäßen Verfahrens zum Kalibrieren einer Positionsmesseinrichtung, welches mit der optischen Einrichtung aus Figur 1 durchgeführt werden kann.

### DETAILLIERTE BESCHREIBUNG DER ERFINDUNG

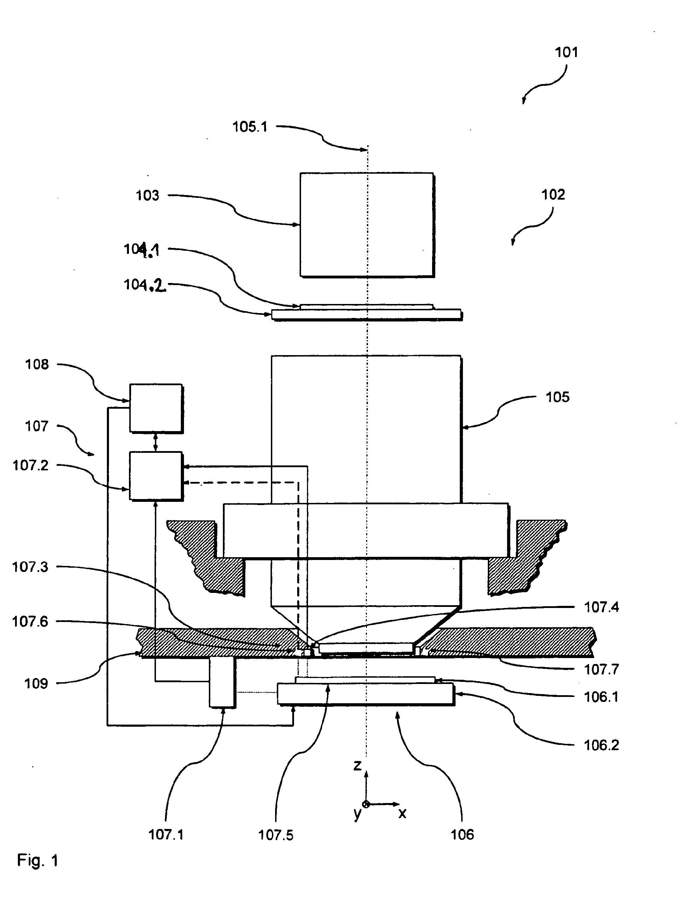

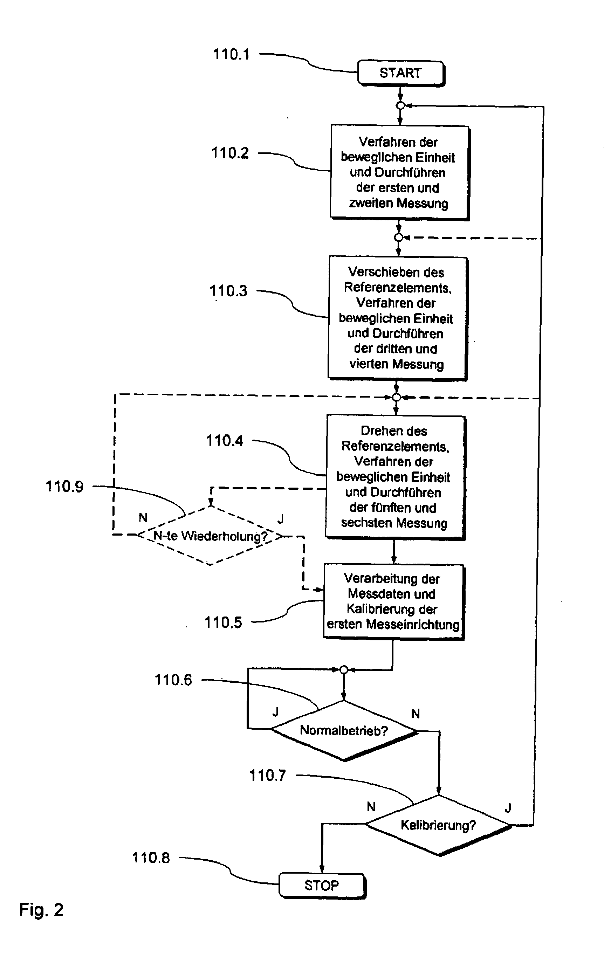

Unter Bezugnahme auf die Figuren 1 und 2 wird im Folgenden eine bevorzugte Ausführungsform der erfindungsgemäßen optischen Einrichtung in Form einer Abbildungseinrichtung 101 für die Mikrolithographie beschrieben, mit der ein bevorzugtes Ausführungsbeispiel des erfindungsgemäßen Verfahrens zum Kalibrieren einer Positionsmesseinrichtung durchgeführt werden kann.

Figur 1 zeigt eine schematische Darstellung einer bevorzugten Ausführungsform der erfindungsgemäßen optischen Einrichtung in Form einer Mikrolithographieeinrichtung 101, die mit Licht einer vorgegebenen Arbeitswellenlänge von 193 nm arbeitet. Es versteht sich jedoch, dass bei anderen Varianten der Erfindung auch andere Wellenlängen zum Einsatz kommen können. Insbesondere kann die Arbeitswellenlänge im extremen UV-Bereich (EUV) im Bereich zwischen 5 nm und 20 nm, typischerweise 13 nm, liegen.

Die Mikrolithographieeinrichtung 101 umfasst ein optisches Projektionssystem 102 mit einem Beleuchtungssystem 103, einer Maskeneinrichtung 104 und einer Projektionseinrichtung in Form eines Objektivs 105 mit einer optischen Achse 105.1. Im Normalbetrieb der Mikrolithographieeinrichtung 101 beleuchtet das Beleuchtungssystem 103 über ein entsprechendes (nicht näher dargestelltes) Lichtleitsystem eine Maske 104.1 der Maskeneinrichtung 104 mit einem (nicht näher dargestellten) Projektionslichtbündel. Auf der Maske 104.1, die auf einem Maskentisch 104.2 angeordnet ist, befindet sich ein Projektionsmuster, welches mit dem Projektionslichtbündel über die im Objektiv 105 angeordneten optischen Elemente auf ein Substrat 106.1, beispielsweise einen so genannten Wafer, projiziert wird, der auf einer beweglichen Einheit in Form eines verfahrbaren Substrattischs 106.2 einer Substrateinrichtung 106 angeordnet ist.

Das Objektiv 105 umfasst zu diesem Zweck eine Reihe von (nicht näher dargestellten) optischen Elementen, die im Gehäuse des Objektivs 105 gelagert sind. Je nach der verwendeten Arbeitswellenlänge kann es sich bei den optischen Elementen um beliebige optische Elemente (Linsen, Spiegel, Gitter etc.) handeln.

Im Normalbetrieb der Mikrolithographieeinrichtung 101 müssen ihre einzelnen an der Abbildung beteiligten Komponenten in eine genau definierte Position und Ausrichtung zueinander gebracht werden, um ein Abbildungsergebnis ausreichender Qualität zu erzielen. Dabei wird unter anderem (entsprechend dem jeweiligen Arbeitsprinzip der Mikrolithographieeinrichtung 101) der Substrattisch 106.2 mit dem (in einer genau definierten Position und Orientierung) darauf befindlichen Substrat 106.1 in bis zu sechs Freiheitsgraden positioniert.

Hierzu wird eine für die Position des Substrattischs 106.2 und damit des Substrats 106.1 in dem jeweiligen Freiheitsgrad repräsentative erste Variable über eine erste Messeinrichtung 107.1 einer Positionsmesseinrichtung 107 erfasst und an eine damit verbundene Verarbeitungseinheit 107.2 der Positionsmesseinrichtung 107 übermittelt. Die Verarbeitungseinheit 107.2 bearbeitet gegebenenfalls die Signale der ersten Messeinrichtung 107.1 und liefert entsprechende Signale an eine Steuereinrichtung 108. Die Steuereinrichtung 108 ermittelt in bekannter Weise eine Abweichung der über die Positionsmesseinrichtung 107 ermittelten aktuellen Position des Substrattischs 106.2 von einer Sollposition des Substrattischs 106.2 und steuert die Antriebseinheit des Substrattischs 106.2 entsprechend an, um dieser Abweichung entgegenzuwirken, mithin also das Substrat 106.1 in den erforderlichen Freiheitsgraden in seine gewünschte Position zu bringen.

Die erste Messeinrichtung 107.1 umfasst im vorliegenden Beispiel ein hinlänglich bekanntes Interferometriesystem, mit dem Änderungen in der Relativposition zwischen der an einer (vorzugsweise thermisch stabilisierten) Stützstruktur 109 befestigten Messeinrichtung 107.1 und dem Substrattisch 106.2 erfasst werden können. Um die absolute Position des Substrattischs 106.2 bezüglich der Messeinrichtung 107.1 bestimmen zu können, umfasst die Messeinrichtung 107.1 in hinlänglich bekannter Weise einen oder mehrere weitere Positionssensoren, mit denen eine anfängliche Startposition des Substrattischs 106.2 bezüglich der Messeinrichtung 107.1 bestimmt werden kann (beispielsweise mechanische Anschläge, oder berührungslos arbeitende Sensoren, wie kapazitive Sensoren etc.).

Es versteht sich jedoch, dass die erste Messeinrichtung bei anderen Varianten der Erfindung auch beliebige andere Einrichtungen zur Bestimmung der Position zwischen der Messeinrichtung und dem Substrattisch umfassen kann. Insbesondere können auch hier Encodersysteme zur Anwendung kommen.

Bei der ersten Messeinrichtung 107.1 besteht das Problem, dass sich beispielsweise durch thermisch bedingte Ausdehnung der Komponenten der Mikrolithographieeinrichtung 101 Änderungen in der Relativposition der Komponenten der ersten Messeinrichtung ergeben, welche Drifteffekte in den Messergebnissen der ersten Messeinrichtung107.1 nach sich ziehen. Diese Drifteffekte bedingen wiederum einen Fehler in der Positionierung des Substrattischs 106.2 und damit einen Abbildungsfehler bei der Belichtung des Substrats 106.1.

Um derartige Drifteffekte möglichst gering zu halten, wird im Betrieb der Mikrolithographieeinrichtung 101 in vorgebbaren Abständen eine Kalibrierung der Positionsmesseinrichtung 107 vorgenommen. Hierzu weist die Positionsmesseinrichtung 107 eine zweite Messeinrichtung in Form eines Encodersystems 107.3 auf. Das Encodersystem 107.3 umfasst eine erste Messeinheit in Form eines ersten Lesekopfes 107.4 und ein zugeordnetes Referenzelement 107.5 mit einem zweidimensionalen Referenzgitter.

Der erste Lesekopf 107.4 ist an der Stützstruktur 109 befestigt, während das Referenzelement 107.5 auf dem Substrattisch 106.2 sitzt. Das Referenzelement 107.5 ist ein Element aus einem thermisch hoch stabilen Glasmaterial mit einem thermischen Ausdehnungskoeffizienten nahe Null (wie beispielsweise Zerodur, ULE Glas etc.). Zusätzlich oder alternativ kann das Referenzelement über eine entsprechende thermische Stabilisierungseinrichtung (z. B. eine aktive oder passive Temperiereinrichtung etc.) thermisch stabilisiert werden (mithin also auf einer vorgebbaren Temperatur gehalten werden).

Auf dieses Referenzelement 107.5 ist das Referenzgitter beispielsweise über einen Belichtungsvorgang aufgebracht. Das Referenzelement 107.5 weist die Abmessungen eines im Normalbetrieb zu belichtenden Substrats 106.1 auf und ist während der Kalibrierung an dessen Stelle in einer genau definierten Position und Orientierung auf dem Substrattisch 106.2 befestigt.

Ein Beispiel für ein derartiges zweidimensionales Encodersystem 107.3 sind die unter der Bezeichnung "Optra NanoGrid Planar Encoder" vertriebenen Encodersysteme der Firma OPTRA, Inc., Topsfield MA 01983, US, die hinsichtlich der Positionsmessung eine Auflösung von weniger als 0,5 nm (genauer eine Auflösung von 0,305 nm) erreichen. Es versteht sich jedoch, dass bei anderen Varianten der Erfindung auch andere geeignete Encodersysteme verwendet werden können. Insbesondere können auch je nach Anzahl der hinsichtlich der Kalibrierung relevanten Freiheitsgrade ein oder mehrere eindimensionale Encodersysteme einzeln oder in Kombination mit einem oder mehreren zweidimensionalen Encodersystemen verwendet werden.

Über das Encodersystem 107.3 kann im vorliegenden Beispiel die Position des Substrattischs 106.2 in zwei translatorischen Freiheitsgraden (x-Richtung und y-Richtung) erfasst werden. Es versteht sich jedoch, dass bei anderen Varianten der Erfindung auch mehrere solcher Encodersysteme vorgesehen sein können, um die Position bzw. Orientierung des Substrattischs in bis zu sechs Freiheitsgraden zu erfassen.

Im Folgenden wird unter Bezugnahme auf die Figuren 1 und 2 der Betrieb der Mikrolithographieeinrichtung 101 sowie das erfindungsgemäße Verfahren zur Kalibrierung der Positionsmesseinrichtung 107 beschrieben. Zunächst wird in einem Schritt 110.1 der Betrieb der Mikrolithographieeinrichtung 101 gestartet.

In einem ersten Messschritt 110.2 wird zunächst das Referenzelement 107.5 auf dem Substrattisch 106.2 in einer vorgegebenen Position und Orientierung befestigt. Dann wird der Substrattisch 106.2 mit dem Referenzelement 107.5 gesteuert durch die Steuereinrichtung 108 nach einem vorgebbaren Schema in den beiden oben genannten Freiheitsgraden (x, y) verfahren. Hierzu wird zunächst eine genau definierte Startposition angefahren, in welcher der Substrattisch eine genau definierte Relativposition zu der Stützstruktur 109 aufweist. Das Erreichen dieser Startposition kann über die oben erwähnten zusätzlichen absoluten Positionssensoren der ersten Messeinrichtung 107.1 1 erfasst werden. Vorzugsweise wird das Erreichen der Startposition jedoch über die zweite Messeinrichtung 107.3 erfasst. Hierzu weist das Referenzelement 107.5 eine oder mehrere entsprechende Referenzmarken auf, welche über den ersten Lesekopf 107.4 erfasst werden.

Wurde erfasst, dass die Startposition erreicht ist, wird der Substrattisch nach dem vorgegebenen Schema verfahren und in einer ersten Messung über die erste Messeinrichtung 107.1 die Position des Substrattischs 106.2 in den beiden oben genannten Freiheitsgraden (x, y) erfasst. Gleichzeitig wird über das Encodersystem 107.3 in einer zweiten Messung die Position des Referenzelements 107.5 und damit ebenfalls die Position des Substrattischs 106.2 in den beiden oben genannten Freiheitsgraden (x, y) erfasst. Die erste Messeinrichtung 107.1 sowie das Encodersystem 107.3 erfassen dabei synchron jeweils eine für die entsprechende Position repräsentative Variable und liefern entsprechende Signale an die Verarbeitungseinheit 107.2.

Vorzugsweise wird gemäß dem vorgebbaren Schema der Nutzbereich des Substrattischs 106.2, also der gesamte Verfahrbereich des Substrattischs 106.2 durchfahren, den dieser auch im Normalbetrieb bei der Belichtung des Substrats 106.1 durchfährt. Dies kann dank der Verwendung des Encodersystems 107.3 in Echtzeit, mithin also mit den Geschwindigkeiten erfolgen, welche der Substrattisch 106.2 im Normalbetrieb bei der Belichtung des Substrats 106.1 erreicht. Begrenzt ist dieser Vorgang nur durch die Verarbeitungsgeschwindigkeit der an der Datensammlung beteiligten Komponenten der Positionsmesseinrichtung 107. Die so gesammelten und gegebenenfalls geeignet aufbereiteten Daten werden (sofort oder zu einem späteren Zeitpunkt) als Ergebnis der ersten und zweiten Messung an die Steuereinrichtung 108 übermittelt.

In einem zweiten Messschritt 110.3 wird zunächst das Referenzelement 107.5 in der Ebene der beiden Freiheitsgrade (x, y) um einen definierten Betrag quer zu einem der beiden Freiheitsgrade durch eine (nicht näher dargestellte) Manipulationseinrichtung versetzt. Der Betrag des Versatzes kann dabei durch das Encodersystem 107.3 überwacht werden. Anschließend wird der Substrattisch erneut nach dem vorgegebenen Schema verfahren und in einer dritten Messung über die erste Messeinrichtung 107.1 die Position des Substrattischs 106.2 in den beiden oben genannten Freiheitsgraden (x, y) erfasst. Gleichzeitig wird über das Encodersystem 107.3 in einer vierten Messung die Position des Referenzelements 107.5 und damit des Substrattischs 106.2 in den beiden Freiheitsgraden (x, y) erfasst. Die erste Messeinrichtung 107.1 sowie das Encodersystem 107.3 erfassen dabei wiederum jeweils eine für die entsprechende Position repräsentative Variable und liefert entsprechende Signale an die Verarbeitungseinheit 107.2. Die so gesammelten und gegebenenfalls geeignet aufbereiteten Daten werden (sofort oder zu einem späteren Zeitpunkt) als Ergebnis der dritten und vierten Messung an die Steuereinrichtung 108 übermittelt.

In einem dritten Messschritt 110.4 wird zunächst das Referenzelement 107.5 durch eine (nicht näher dargestellte) Manipulationseinrichtung in der Ebene der beiden Freiheitsgrade (x, y) um einen definierten Winkel, vorzugsweise 90°, gedreht. Der Betrag der Drehung kann dabei durch eine geeignete Sensoreinrichtung überwacht werden. Anschließend wird der Substrattisch 106.2 erneut nach dem vorgegebenen Schema verfahren und in einer fünften Messung über die erste Messeinrichtung 107.1 die Position des Substrattischs 106.2 in den beiden oben genannten Freiheitsgraden (x, y) erfasst. Gleichzeitig wird über das Encodersystem 107.3 in einer sechsten Messung die Position des Referenzelements 107.5 und damit des Substrattischs 106.2 in den beiden Freiheitsgraden (x, y) erfasst. Die erste Messeinrichtung 107.1 sowie das Encodersystem 107.3 erfassen dabei wiederum jeweils eine für die entsprechende Position repräsentative Variable und liefert entsprechende Signale an die Verarbeitungseinheit 107.2. Die so gesammelten und gegebenenfalls geeignet aufbereiteten Daten werden (sofort oder zu einem späteren Zeitpunkt) als Ergebnis der fünften und sechsten Messung an die Steuereinrichtung 108 übermittelt.

Die Verschiebung des Referenzgitters in dem zweiten Messschritt 110.3 und die Verdrehung des Referenzgitters in dem dritten Messschritt 110.4 dienen dazu, systematische Fehler des Encodersystems 107.3, beispielsweise Verzerrungen und Orthogonalitätsfehler des Referenzgitters etc. (welche z. B. dem Referenzgitter inhärent sind oder von einer Deformation des Referenzgitter bei seiner Befestigung am Substrattisch 106.2 herrühren) zu erfassen und bei der Kalibrierung entsprechend berücksichtigen zu können.

Es versteht sich jedoch, das bei anderen Varianten der Erfindung eine solche Verschiebung und/oder Verdrehung des Referenzelements, wenn überhaupt, nur mit erhöhtem Aufwand möglich ist. In diesem Fall kann vorgesehen sein, dass die zweite Messeinrichtung 107.3 einen zweiten Lesekopf umfasst, wie er in Figur 1 durch die gestrichelte Kontur107.6 angedeutet ist. Anstelle der Verschiebung des Referenzelements kann dann vorgesehen sein, dass in dem zweiten Messschritt die vierte Messung nicht über den ersten Lesekopf 107.4 erfolgt sondern über den zweiten Lesekopf 107.6.

Der zweite Lesekopf 107.6 ist in einer genau definierten Position bezüglich des ersten Lesekopfes 107.4 angeordnet. Vorzugsweise ist dabei vorgesehen, das die beiden Leseköpfe107.4 und 107.6 in einer gemeinsamen thermisch stabilen oder durch geeignete Mittel thermisch stabilisierten Halterung angeordnet sind, um die Relativposition der beiden Leseköpfe 107.4 und 107.6 stabil zu halten. Vorzugsweise ist die Halterung dabei aus einem thermisch stabilen Material mit einem thermischen Ausdehnungskoeffizienten nahe Null (wie beispielsweise Zerodur, ULE Glas etc.) aufgebaut, um dies in einfacher Weise zu gewährleisten.

Weiterhin versteht es sich, dass die Verdrehung des Referenzelements 107.5 nicht notwendigerweise nach dem Versetzen des Referenzelements 107.5 erfolgen muss. Vielmehr kann auch umgekehrt zunächst die Messung an dem gedrehten Referenzelement und anschließend die Messung an dem seitlich versetzten Referenzelement erfolgen. Weiterhin versteht es sich, dass der zweite bzw. dritte Messschritt nicht notwendigerweise erfolgen muss. Vielmehr kann auch einer dieser beiden Messschritte fehlen.

In einem Kalibrierungsschritt 110.5 ermittelt die Steuereinrichtung 108 dann zum einen aus den Ergebnissen der zweiten, vierten und sechsten Messung systematische Fehler des Encodersystems und speichert diese in einem entsprechenden Korrekturdatensatz. Weiterhin werden aus den Ergebnissen der ersten bis sechsten Messung (unter Verwendung des Korrekturdatensatzes) die Abweichungen der Messungen der ersten Messeinrichtung 107.1 von den Messungen des Encodersystems107.3 ermittelt und hieraus in bekannter Weise Kalibrierwerte für die erste Messeinrichtung 107.1 ermittelt, die in einem Kalibrierdatensatz gespeichert werden und zur Kalibrierung der Messeinrichtung 107.1 verwendet werden.

In einem Schritt 110.6 wird dann überprüft, ob der Normalbetrieb der Mikrolithograpieeinrichtung 101 durchgeführt werden soll. Ist dies der Fall, wird der Normalbetrieb aufgenommen und solange durchgeführt, bis in dem parallel hierzu kontinuierlich wiederholten Schritt 110.6 erfasst wird, dass der Normalbetrieb unterbrochen werden soll.

Ist dies der Fall, wird in einem Schritt 110.7 überprüft, ob eine weitere Kalibrierung durchgeführt werden soll. Ist dies nicht der Fall, wird der Verfahrensablauf in einem Schritt 110.8 beendet. Andernfalls wird zurück zu dem Schritt 110.2 gesprungen. Es versteht sich jedoch, dass bei anderen Varianten der Erfindung auch vorgesehen sein kann, dass für die erneute Kalibrierung nicht alle drei Messschritte 110.2 bis 110.4 wiederholt werden. Vielmehr kann vorgesehen sein, das zwei oder auch nur einer der Messschritte 110.2 bis 110.4 (mit dem dann erneut auf den Substrattisch 106.2 befestigten Referenzelement 107.5) wiederholt werden. Gegebenenfalls kann also auch nur zu dem Schritt 110.3 (Wiederholung des zweiten Messschritts 110.3 und des dritten Messschritts 110.4) zurück gesprungen werden, wobei dann gegebenenfalls auch der Versatz des Referenzelements 107.5 nicht erforderlich ist. Ebenso kann auch nur zu dem Schritt 110.4 zurück gesprungen werden (Wiederholung des dritten Messschritts 110.4), wobei dann gegebenenfalls auch die Drehung des Referenzelements 107.5 nicht erforderlich ist.

Eine Wiederholung eines Teils der Messschritte kann dann gewählt werden, wenn die systematischen Fehler des Encodersystems 107.3 aus dem einer vorangehenden Kalibrierung ermittelten Korrekturdatensatz bzw. Kalibrierdatensatz für die Kalibrierung in dem erneuten Kalibrierungsschritt 110.5 herangezogen werden und keine nennenswerte Änderung des systematischen Fehlers durch das erneute Befestigen des Referenzelements 107.5 auf den Substrattisch 106.2 zu erwarten ist.

Weiterhin ist es bei anderen Varianten der Erfindung möglich, dass bei der ersten Kalibrierung und/oder bei (einzelnen oder allen) nachfolgenden Kalibrierungen der dritte Messschritt 110.4 zur Erhöhung der Genauigkeit N-mal wiederholt wird. Die Anzahl N der Wiederholungen kann beliebig vorgegeben werden.

Hierzu kann nach dem Messschritt 110.4 in einem Überprüfungsschritt 110.9 überprüft werden, und die N-te Wiederholung erreicht ist. Ist dies der Fall, wird zum Kalibrierungsschritt 110.5 übergegangen. Andernfalls wird zum dritten Messschritt 110.4 zurück gesprungen, wobei dann eine erneute Drehung des Referenzelementes 107.5 erfolgt. Hierdurch ist es beispielsweise möglich, Messungen mit dem Referenzelement 107.5 in mehreren Drehpositionen vorzunehmen (z. B. 0°, 90°, 180°, 270°).

Wie bereits oben erläutert wurde, kann über das Encodersystem 107.3 im vorliegenden Beispiel die Position des Substrattischs 106.2 in zwei translatorischen Freiheitsgraden (x-Richtung und y-Richtung) erfasst werden. Wie erwähnt, können bei anderen Varianten der Erfindung auch mehrere solcher Encodersysteme vorgesehen sein, um die Position bzw. Orientierung des Substrattischs in bis zu sechs Freiheitsgraden zu erfassen. Hierbei versteht es sich, dass sich diese Encodersysteme das Referenzelement 107.5 teilen können. Insbesondere kann beispielsweise über einen dem ersten Lesekopf 107.4 (bezüglich des Objektivs 105) gegenüberliegend angeordneten dritten Lesekopf 107.7 in einem oder mehreren der Messschritte 110.2 bis 110.4 (unter Verwendung des Referenzelements 107.5) eine parallele Messung vorgenommen werden, um die Genauigkeit der späteren Kalibrierung zu erhöhen. Ein weiterer Vorteil dieser Lösung besteht darin, dass eine Messung über den gesamten Verfahrbereich des Substrattischs 106.2 möglich ist.

Dank der mit dem erfindungsgemäßen Verfahren möglichen schnellen Datenerfassung in Echtzeit kann gegenüber den bekannten Kalibrierverfahren eine deutliche Reduktion der Kalibrierdauer erzielt werden. Bei dem soeben beschriebenen erfindungsgemäßen Kalibrierverfahren ist eine Reduktion auf eine Kalibrierdauer in der Größenordnung von 5 Minuten möglich. Durch die Wiederholung nur eines Teils der Messschritte bei einer nachfolgenden Kalibrierung lässt sich die Kalibrierdauer noch weiter reduzieren. Demgemäß kann die Kalibrierung in kürzeren Abständen durchgeführt werden, um die Genauigkeit der Mikrolithographieeinrichtung 101 zu erhöhen, oder (bei ausreichender Stabilität der Mikrolithographieeinrichtung 101 zwischen den Kalibrierungen) bei gleich bleibenden Abständen zwischen den Kalibrierungen der Durchsatz und damit die Produktivität der Mikrolithographieeinrichtung 101 erhöht werden.

Ein weiterer Vorteil der vorliegenden Erfindung besteht darin, dass die zweite Messeinrichtung 107.3 so nahe an dem Nutzbereich des Substrattischs 106.2 angeordnet ist, dass sich der Messbereich der zweiten Messeinrichtung107.3 mit dem Nutzbereich des Substrattischs 106.2 im Wesentlichen deckt. Hierdurch ist es in vorteilhafter Weise möglich, zur Kalibrierung einen Bereich heranzuziehen, der nahe an dem interessierenden Arbeitsbereich des Substrattischs 106.2, dessen exakte Positionierung im Normalbetrieb der Mikrolithographieeinrichtung 101 über die Messungen der zu kalibrierenden ersten Messeinrichtung 107.1 erfolgen soll.

Mithin erfolgt also die Referenzmessung zumindest nahe an dem im Normalbetrieb interessierenden Bereich, für dessen Positionierung im Normalbetrieb die Messungen der zu kalibrierenden Positionsmesseinrichtung verwendet werden. Es versteht sich jedoch, dass bei anderen Varianten der Erfindung auch vorgesehen sein kann, dass das Referenzelement an anderer Stelle des Substrattischs angeordnet ist, sodass sich der Messbereich des Encodersystems und der im Normalbetrieb (über die Messungen der zu kalibrierenden ersten Messeinrichtung zu positionierende) interessierende Bereich lediglich überlappen oder gegebenenfalls sogar keinerlei Berührung aufweisen.

Die vorliegende Erfindung wurde vorstehend anhand von Beispielen beschrieben, bei denen das bewegliche Element der optischen Einrichtung ein Substrattisch einer Mikrolithographieeinrichtung ist. Es versteht sich jedoch, dass die Erfindung auch im Zusammenhang mit anderen beweglichen Komponenten der Mikrolithographieeinrichtung (beispielsweise dem ebenfalls beweglichen Maskentisch der Mikrolithographieeinrichtung) ebenso zum Einsatz kommen kann wie im Zusammenhang mit anderen optischen Einrichtungen. Insbesondere ist es beispielsweise möglich, die Erfindung im Zusammenhang mit der Inspektion von Masken und belichteten Substraten (wie Wafern etc.) einzusetzen, da hier ebenfalls die beweglichen Komponenten, welche die zu inspizierenden Masken bzw. Substrate tragen, mit einer entsprechend hohen Genauigkeit zu positionieren sind..

Weiterhin ist anzumerken, dass die vorliegende Erfindung vorstehend anhand eines Beispiels aus dem Bereich der Mikrolithographie beschrieben wurde. Es versteht sich jedoch, dass die vorliegende Erfindung ebenso auch für beliebige andere Anwendungen bzw. Abbildungsverfahren eingesetzt werden kann.

Die Erfindung ist durch die Ansprüche definiert.

## Patentansprüche

1. Verfahren zum Kalibrieren einer Positionsmesseinrichtung (107) einer optischen Einrichtung (101), bei dem
- in einem Messschritt (110.2) eine bewegliche Einheit (106.2) der optischen Einrichtung (101) nach einem vorgebbaren Schema in wenigstens einem Freiheitsgrad bewegt wird und eine Position der beweglichen Einheit (106.2) in dem wenigstens einen Freiheitsgrad erfasst wird, wobei
- die Position der beweglichen Einheit (106.2) in dem wenigstens einen Freiheitsgrad in einer ersten Messung über eine erste Messeinrichtung (107.1) der Positionsmesseinrichtung (107) erfasst wird und
- die Position der beweglichen Einheit (106.2) in dem wenigstens einen Freiheitsgrad in einer zweiten Messung über eine zweite Messeinrichtung (107.3) der Positionsmesseinrichtung (107) unter Verwendung eines mit der beweglichen Einheit (106.2) verbundenen Referenzelements (107.5) erfasst wird, und
- in einem Kalibrierungsschritt (110.5) die erste Messeinrichtung (107.1) unter Verwendung der Ergebnisse der ersten Messung und der zweiten Messung kalibriert wird,
**dadurch gekennzeichnet, dass**
- als zweite Messeinrichtung (107.3) ein Encodersystem verwendet wird, wobei
- das Referenzelement (107.5) ein Referenzgitter des Encodersystems (107.3) umfasst.

2. Verfahren nach Anspruch 1, **dadurch gekennzeichnet, dass**
- als Encodersystem (107.3) ein zweidimensionales Encodersystem verwendet wird, wobei als Referenzgitter ein zweidimensionales Gitter verwendet wird,
und/oder
- als Encodersystem (107.3) ein hochauflösendes Encodersystem verwendet wird, dessen Auflösung unterhalb von einem Nanometer liegt,

3. Verfahren nach Anspruch 1 oder 2, **dadurch gekennzeichnet, dass**
- als Referenzelement (107.5) ein Element mit einem geringen thermischen
Ausdehnungskoeffizienten verwendet wird
und/oder
- das Referenzelement (107.5) über eine thermische Stabilisierungseinrichtung thermisch stabilisiert wird.

4. Verfahren nach einem der Ansprüche 1 bis 3, **dadurch gekennzeichnet, dass**
- der Messschritt (110.2) ein erster Messschritt ist und
- in einem zweiten Messschritt (110.3) die bewegliche Einheit (106.2) nach einem vorgebbaren Schema in dem wenigstens einen Freiheitsgrad bewegt wird und eine Position der beweglichen Einheit (106.2) in dem wenigstens einen Freiheitsgrad erfasst wird, wobei
- in einer dritten Messung über die erste Messeinrichtung (107.1) in dem wenigstens einen Freiheitsgrad die Position der beweglichen Einheit (106.2) erfasst wird,
- in einer vierten Messung über die zweite Messeinrichtung (107.3) in dem wenigstens einen Freiheitsgrad die Position der beweglichen Einheit (106.2) unter Verwendung des Referenzelements (107.5) erfasst wird und
- in dem Kalibrierungsschritt (110.5) die erste Messeinrichtung (107.1) unter Verwendung der Ergebnisse der ersten Messung, der zweiten Messung, der dritten Messung und der vierten Messung kalibriert wird.

5. Verfahren nach Anspruch 4, **dadurch gekennzeichnet, dass** die bewegliche Einheit (106.2) in dem zweiten Messschritt (110.3) nach demselben Schema wie in dem ersten Messschritt (110.2) bewegt wird.

6. Verfahren nach Anspruch 4 oder 5, **dadurch gekennzeichnet, dass**
- das Referenzelement (107.5) in dem ersten Messschritt (110.2) eine erste Position und eine erste Orientierung bezüglich der beweglichen Einheit (106.2) aufweist und
- das Referenzelement (107.5) vor dem zweiten Messschritt (110.3) in eine vorgebbare zweite Position und/oder eine vorgebbare zweite Orientierung bezüglich der beweglichen Einheit (106.2) gebracht wird, wobei
- die erste Position gegenüber der zweiten Position verschieden ist und/oder die erste Orientierung gegenüber der zweiten Orientierung verschieden ist.

7. Verfahren nach einem der Ansprüche 4 bis 6, **dadurch gekennzeichnet, dass**
- die Position der beweglichen Einheit (106.2) in dem wenigstens einen Freiheitsgrad für die zweite Messung unter Verwendung einer ersten Messeinheit (107.4) der zweiten Messeinrichtung (107.3) erfasst wird und
- die Position der beweglichen Einheit (106.2) in dem wenigstens einen Freiheitsgrad für die vierte Messung unter Verwendung einer zweiten Messeinheit (107.6) der zweiten Messeinrichtung (107.3) erfasst wird, wobei
- die zweite Messeinheit (107.6) bezüglich der ersten Messeinheit (107.4) quer zu der Richtung entlang des wenigstens einen Freiheitsgrades versetzt angeordnet ist.

8. Verfahren nach einem der Ansprüche 4 bis 7, **dadurch gekennzeichnet, dass**
- in einem dritten Messschritt (110.4) die bewegliche Einheit (106.2) nach einem vorgebbaren Schema in dem wenigstens einen Freiheitsgrad bewegt wird und eine Position der beweglichen Einheit (106.2) in dem wenigstens einen Freiheitsgrad erfasst wird, wobei
- in einer fünften Messung über die erste Messeinrichtung (107.1) in dem wenigstens einen Freiheitsgrad die Position einer beweglichen Einheit (106.2) der optischen Einrichtung (101) erfasst wird,
- in einer sechsten Messung über die zweite Messeinrichtung (107.3) in dem wenigstens einen Freiheitsgrad die Position der beweglichen Einheit (106.2) unter Verwendung des Referenzelements (107.5) erfasst wird und
- in dem Kalibrierungsschritt (110.5) die erste Messeinrichtung (107.1) unter Verwendung der Ergebnisse der ersten Messung, der zweiten Messung, der dritten Messung, der vierten Messung, der fünften Messung und der sechsten Messung kalibriert wird.

9. Verfahren nach Anspruch 8, **dadurch gekennzeichnet, dass** die bewegliche Einheit (106.2) in dem dritten Messschritt (110.4) nach demselben Schema wie in den ersten Messschritt (110.2) und/oder dem zweiten Messschritt (110.3) bewegt wird.

10. Verfahren nach Anspruch 8 oder 9, **dadurch gekennzeichnet, dass**
- das Referenzelement (107.5) in dem ersten Messschritt (110.2) eine erste Position und erste Orientierung bezüglich der beweglichen Einheit (106.2) aufweist und
- das Referenzelement (107.5) vor dem zweiten Messschritt (110.3) in eine vorgebbare zweite Position bezüglich der beweglichen Einheit (106.2) gebracht wird und das Referenzelement (107.5) vor dem dritten Messschritt (110.4) in eine vorgebbare dritte Orientierung bezüglich der beweglichen Einheit (106.2) gebracht wird, wobei
- die erste Position und die zweite Position zueinander verschieden sind und die erste Orientierung und die dritte Orientierung zueinander verschieden sind,
oder
- das Referenzelement (107.5) vor dem zweiten Messschritt (110.3) in eine vorgebbare zweite vorgebbare zweite Orientierung bezüglich der beweglichen Einheit (106.2) gebracht wird und das Referenzelement (107.5) vor dem dritten Messschritt (110.4) in eine vorgebbare dritte Position bezüglich der beweglichen Einheit (106.2) gebracht wird, wobei
- die erste Position und die dritte Position zueinander verschieden sind und die erste Orientierung und die zweite Orientierung zueinander verschieden sind.

11. Verfahren nach einem der Ansprüche 4 bis 10, **dadurch gekennzeichnet, dass**
- der Kalibrierungsschritt (110.5) ein erster Kalibrierungsschritt ist und wenigstens das Ergebnis der zweiten Messung und das Ergebnis der vierten Messung zum Eliminieren eines systematischen Fehlers des Encodersystems (107.3) ausgewertet wird und das Ergebnis der Auswertung in einem Referenzdatensatz gespeichert wird sowie
- in einem dem ersten Kalibrierungsschritt (110.5) nachfolgenden vierten Messschritt (110.2; 110.3; 110.4) die bewegliche Einheit (106.2) nach einem vorgebbaren Schema in dem wenigstens einen Freiheitsgrad bewegt wird und eine Position der beweglichen Einheit (106.2) in dem wenigstens einen Freiheitsgrad erfasst wird, wobei
- in einer siebten Messung über die erste Messeinrichtung (107.1) in dem wenigstens einen Freiheitsgrad die Position der beweglichen Einheit (106.2) erfasst wird,
- in einer achten Messung über die zweite Messeinrichtung (107.3) in dem wenigstens einen Freiheitsgrad die Position der beweglichen Einheit unter Verwendung des Referenzelements erfasst wird und
- in einem zweiten Kalibrierungsschritt (110.5) die erste Messeinrichtung (107.1) unter Verwendung des Referenzdatensatzes und der Ergebnisse der siebten Messung und der achten Messung kalibriert wird.

12. Verfahren nach einem der Ansprüche 1 bis 11, **dadurch gekennzeichnet, dass**
- die bewegliche Einheit (106.2) einen Nutzbereich definiert, dessen Position in einem Normalbetrieb der optischen Einrichtung (101) über die erste Messeinrichtung (107.1) zu erfassen ist, und
- die zweite Messeinrichtung (107.3) zumindest in der zweiten Messung einen Messbereich des Referenzelements (107.5) erfasst, wobei
- der Messbereich zumindest nahe an dem Nutzbereich angeordnet ist.

13. Verfahren nach einem der Ansprüche 1 bis 12, **dadurch gekennzeichnet, dass**
- die optischen Einrichtung (101) einen Arbeitsbereich definiert, in dem die bewegliche Einheit (106.2) in einem Normalbetrieb der optischen Einrichtung (101) bewegt wird, und
- die bewegliche Einheit (106.2) in dem Messschritt (110.2) in dem wenigstens einen Freiheitsgrad zumindest über einen Großteil des Arbeitsbereichs bewegt wird.

14. Verfahren nach einem der Ansprüche 1 bis 13, **dadurch gekennzeichnet, dass** zumindest während der zweiten Messung zumindest eine Referenzmarke des Referenzelements (107.5) durch die zweite Messeinrichtung (107.3) erfasst wird.

15. Verfahren nach einem der Ansprüche 1 bis 14 dass es zum Kalibrieren einer Positionsmesseinrichtung für einen Maskentisch (104.2) einer Mikrolithographieeinrichtung (101), zum Kalibrieren einer Positionsmesseinrichtung (107) für einen Substrattisch (106.2) einer Mikrolithographieeinrichtung (101), zum Kalibrieren einer Positionsmesseinrichtung für einen Substrattisch einer Substratinspektionseinrichtung oder zum Kalibrieren einer Positionsmesseinrichtung für einen Maskentisch einer Maskeninspektionseinrichtung verwendet wird.

16. Optische Einrichtung, insbesondere für die Mikrolithographie, mit
- einer durch eine Antriebseinheit verfahrbaren beweglichen Einheit (106.2),
- einer Steuereinrichtung (108) und
- einer Positionsmesseinrichtung (107), wobei
- die Positionsmesseinrichtung (107) eine erste Messeinrichtung (107.1) und eine zweite Messeinrichtung (107.3) umfasst,
- die Positionsmesseinrichtung (107) dazu ausgebildet ist, in einem Messschritt eine Position der durch die Antriebseinheit nach einem vorgebbaren Schema verfahrenen beweglichen Einheit (106.2) in wenigstens einem Freiheitsgrad zu erfassen,
- die erste Messeinrichtung (107.1) dazu ausgebildet ist, eine für die Position der beweglichen Einheit (106.2) in dem wenigstens einen Freiheitsgrad repräsentative erste Variable in einer ersten Messung zu erfassen und an die Steuereinrichtung (108) zu übergeben,
- die zweite Messeinrichtung (107.3) ein mit der beweglichen Einheit (106.2) verbundenes Referenzelement (107.5) umfasst und dazu ausgebildet ist, eine für die Position der beweglichen Einheit (106.2) in dem wenigstens einen Freiheitsgrad repräsentative zweite Variable in einer zweiten Messung unter Verwendung des Referenzelements (107.5) zu erfassen und an die Steuereinrichtung (108) zu übergeben, und
- die Steuereinrichtung (108) dazu ausgebildet ist, in einem Kalibrierungsschritt die erste Messeinrichtung (107.1) unter Verwendung der Ergebnisse der ersten Messung und der zweiten Messung zu kalibrieren,
**dadurch gekennzeichnet, dass**
- die zweite Messeinrichtung ein Encodersystem (107.3) umfasst, wobei
- das Referenzelement (107.5) ein Referenzgitter des Encodersystems (107.3) umfasst.

17. Optische Einrichtung nach Anspruch 16, **dadurch gekennzeichnet, dass**
- das Encodersystem (107.3) ein zweidimensionales Encodersystem mit einem zweidimensionalen Referenzgitter ist
und/oder
- das Encodersystem (107.3) ein hochauflösendes Encodersystem mit einer Auflösung unterhalb von einem Nanometer ist.

18. Optische Einrichtung nach Anspruch 16 oder 17, **dadurch gekennzeichnet, dass**
- das Referenzelement (107.5) einen geringen thermischen Ausdehnungskoeffizienten aufweist
und/oder
- eine thermische Stabilisierungseinrichtung vorgesehen ist, die dazu ausgebildet ist, das Referenzelement (107.5) thermisch zu stabilisieren.

19. Optische Einrichtung nach einem der Ansprüche 16 bis 18, **dadurch gekennzeichnet, dass**
- der Messschritt ein erster Messschritt ist,
- die Positionsmesseinrichtung (107) dazu ausgebildet ist, wenigstens in einem zweiten Messschritt eine Position der durch die Antriebseinheit nach einem vorgebbaren Schema verfahrenen beweglichen Einheit (106.2) in wenigstens einem Freiheitsgrad zu erfassen,
- die erste Messeinrichtung (107.1) dazu ausgebildet ist, eine für die Position der beweglichen Einheit (106.2) in dem wenigstens einen Freiheitsgrad repräsentative erste Variable in einer dritten Messung zu erfassen und an die Steuereinrichtung (108) zu übergeben,
- die zweite Messeinrichtung (107.3) dazu ausgebildet ist, eine für die Position der beweglichen Einheit (106.2) in dem wenigstens einen Freiheitsgrad repräsentative zweite Variable in einer vierten Messung unter Verwendung des Referenzelements (107.5) zu erfassen und an die Steuereinrichtung (108) zu übergeben, und
- die Steuereinrichtung (108) dazu ausgebildet ist, in dem Kalibrierungsschritt die erste Messeinrichtung (107.1) unter Verwendung der Ergebnisse der ersten Messung, der zweiten Messung, der dritten Messung und der vierten Messung zu kalibrieren.

20. Optische Einrichtung nach Anspruch 19, **dadurch gekennzeichnet, dass**
- das Referenzelement (107.5) in dem ersten Messschritt eine erste Position und eine erste Orientierung bezüglich der beweglichen Einheit (106.2) aufweist und
- eine Manipulationseinrichtung vorgesehen ist, wie dazu ausgebildet ist, das Referenzelement (107.5) vor dem zweiten Messschritt in eine vorgebbare zweite Position und/oder eine vorgebbare zweite Orientierung bezüglich der beweglichen Einheit (106.2) zu bringen, wobei
- die erste Position gegenüber der zweiten Position verschieden ist und/oder die erste Orientierung gegenüber der zweiten Orientierung verschieden ist.

21. Optische Einrichtung nach Anspruch 19 oder 20, **dadurch gekennzeichnet, dass**
- die zweite Messeinrichtung (107.3) eine erste Messeinheit (107.4) und eine zweite Messeinheit (107.6) umfasst, wobei
- die erste Messeinheit (107.4) dazu ausgebildet ist, für die zweite Messung eine für die Position der beweglichen Einheit (106.2) in dem wenigstens einen Freiheitsgrad repräsentative Variable zu erfassen, und
- die zweite Messeinheit (107.6) dazu ausgebildet ist, für die vierte Messung eine für die Position der beweglichen Einheit (106.2) in dem wenigstens einen Freiheitsgrad repräsentative Variable zu erfassen, wobei
- die zweite Messeinheit (107.6) bezüglich der ersten Messeinheit (107.4) quer zu der Richtung entlang des wenigstens einen Freiheitsgrades versetzt angeordnet ist,
- wobei die erste Messeinheit (107.4) und die zweite Messeinheit (107.6) insbesondere an einem gemeinsamen, insbesondere thermisch stabilisierten, Stützelement (109) angeordnet sind.

22. Optische Einrichtung nach 20 oder 21, **dadurch gekennzeichnet, dass**
- der Kalibrierungsschritt ein erster Kalibrierungsschritt ist und die Steuereinrichtung (108) dazu ausgebildet ist, wenigstens das Ergebnis der zweiten Messung und das Ergebnis der vierten Messung zum Eliminieren eines systematischen Fehlers des Encodersystems (107.3) auszuwerten und das Ergebnis der Auswertung in einem Referenzdatensatz zu speichern sowie
- die Positionsmesseinrichtung (107) dazu ausgebildet ist, wenigstens in einem dem ersten Kalibrierungsschritt nachfolgenden weiteren Messschritt eine Position der die nach einem vorgebbaren Schema in dem wenigstens einen Freiheitsgrad verfahrenen beweglichen Einheit (106.2) in dem wenigstens einen Freiheitsgrad zu erfassen, wobei
- die erste Messeinrichtung (107.1) dazu ausgebildet ist, eine für die Position der beweglichen Einheit (106.2) in dem wenigstens einen Freiheitsgrad repräsentative erste Variable in einer siebten Messung zu erfassen und an die Steuereinrichtung (108) zu übergeben,
- die zweite Messeinrichtung (107.3) dazu ausgebildet ist, eine für die Position der beweglichen Einheit (106.2) in dem wenigstens einen Freiheitsgrad repräsentative zweite Variable in einer achten Messung unter Verwendung des Referenzelements (107.5) zu erfassen und an die Steuereinrichtung (108) zu übergeben, und
- die Steuereinrichtung (108) dazu ausgebildet ist, in einem zweiten Kalibrierungsschritt die erste Messeinrichtung (107.1) unter Verwendung des Referenzdatensatzes und der Ergebnisse der siebten Messung und der achten Messung zu kalibrieren.

23. Optische Einrichtung nach einem der Ansprüche 16 bis 22, **dadurch gekennzeichnet, dass**
- die bewegliche Einheit (106.2) einen Nutzbereich definiert, dessen Position in einem Normalbetrieb der optischen Einrichtung über die erste Messeinrichtung (107.1) zu erfassen ist, und die zweite Messeinrichtung (107.3) zumindest in der zweiten Messung einen Messbereich des Referenzelements (107.5) erfasst, wobei der Messbereich zumindest nahe an dem Nutzbereich angeordnet ist.
und/oder
- die optischen Einrichtung (101) einen Arbeitsbereich definiert, in dem die bewegliche Einheit (106.2) in einem Normalbetrieb der optischen Einrichtung (101) bewegt wird, und die Antriebseinheit dazu ausgebildet ist, die bewegliche Einheit (106.2) in dem Messschritt in dem wenigstens einen Freiheitsgrad zumindest über einen Großteil des Arbeitsbereichs zu verfahren.

24. Optische Einrichtung nach einem der Ansprüche 16 bis 23, **dadurch gekennzeichnet, dass** die zweite Messeinrichtung (107.3) dazu ausgebildet ist, zumindest während der zweiten Messung zumindest eine Referenzmarke des Referenzelements (107.5) zu erfassen.

25. Optische Einrichtung nach einem der Ansprüche 16 bis 24, **dadurch gekennzeichnet, dass** die Positionsmesseinrichtung (107) eine Positionsmesseinrichtung für einen Maskentisch (104.2) einer Mikrolithographieeinrichtung (101), eine Positionsmesseinrichtung für einen Substrattisch (106.2) einer Mikrolithographieeinrichtung (101), eine Positionsmesseinrichtung für einen Substrattisch einer Substratinspektionseinrichtung oder eine Positionsmesseinrichtung für einen Maskentisch einer Maskeninspektionseinrichtung ist.

## Claims

1. Method for calibrating a positioning measuring device (107) of an optical device (100), in which
- in a measurement step (110.2), a movable unit (106.2) of the optical device (101) is moved according to a pre-definable scheme in at least one degree of freedom and a position of the movable unit (106.2) is captured in the at least one degree of freedom, wherein
- the position of the movable unit (106.2) is captured in the at least one degree of freedom in a first measurement via a first measuring device (107.1) of the position measuring device (107) and
- the position of the movable unit (106.2) is captured in the at least one degree of freedom in a second measurement via a second measuring device (107.3) of the position measuring device (107) using a reference element (107.5) connected to the movable unit (106.2) and
- in a calibration step (110.5), the first measuring device (107.1) is calibrated using the results of the first measurement and the second measurement,
**characterised in that**
- an encoder system is used as the second measuring device (107.3), wherein
- the reference element (107.5) comprises a reference grid of the encoder system (107.3).

2. Method according to Claim 1, **characterised in that**
- a two-dimensional encoder system is used as the encoder system (107.3), wherein a two-dimensional grid is used as the reference grid,
and/or
- a high-resolution encoder system is used as the encoder system (107.3), the resolution of which is below one nanometre.

3. Method according to Claim 1 or 2, **characterised in that**
- an element having a low coefficient of thermal expansion is used as the reference element (107.5)
and/or
- the reference element (107.5) is thermally stabilised via a thermal stabilisation device.

4. Method according to any one of Claims 1 to 3, **characterised in that**
- the measurement step (110.2) is a first measurement step and
- in a second measurement step (110.3) the movable unit (105.2) is moved according to a pre-definable scheme in the at least one degree of freedom and a position of the movable unit (106.2) is captured in the at least one degree of freedom, wherein
- in a third measurement, the position of the movable unit (106.2) is captured in the at least one degree of freedom via the first measuring device (107.1),
- in a fourth measurement, the position of the movable unit (106.2) is captured in the at least one degree of freedom via the second measuring device (107.3) using the reference element (107.5) and
- in the calibration step (110.5), the first measuring device (107.1) is calibrated using the results of the first measurement, the second measurement, the third measurement and the fourth measurement.

5. Method according to Claim 4, **characterised in that** the movable unit (106.2) is moved in the second measurement step (110.3) according to the same scheme as in the first measurement step (110.2).

6. Method according to Claim 4 or 5, **characterised in that**
- in the first measurement step (110.2), the reference element (107.5) has a first position and a first orientation with respect to the movable unit (106.2) and
- before the second measurement step (110.3), the reference element (107.5) is moved into a pre-definable second position and/or a pre-definable second orientation with respect to the movable unit (106.2), wherein
- the first position is different from the second position, and/or the first orientation is different from the second orientation.

7. Method according to any one of Claims 4 to 6, **characterised in that**
- for the second measurement, the position of the movable unit (106.2) is determined in the at least one degree of freedom using a first measuring unit (107.4) of the second measuring device (107.3) and
- for the fourth measurement, the position of the movable unit (106.2) is determined in the at least one degree of freedom using a second measuring unit (107.6) of the second measuring device (107.3), wherein
- relative to the first measuring unit (107.4), the second measuring unit (107.6) is displaced transversely with respect to the direction along the at least one degree of freedom.

8. Method according to any one of Claims 4 to 7, **characterised in that**
- in a third measurement step (110.4), the movable unit (106.2) is moved according to a pre-definable scheme in the at least one degree of freedom and a position of the movable unit (106.2) is captured in the at least one degree of freedom, wherein
- in a fifth measurement, the position of a movable unit (106.2) of the optical device (101) is captured in the at least one degree of freedom via the first measuring device (107.1),
- in a sixth measurement, the position of the movable unit (106.2) is captured in the at least one degree of freedom via the second measuring device (107.3) using the reference element (107.5) and
- in the calibration step (110.5), the first measuring device (107.1) is calibrated using the results of the first measurement, the second measurement, the third measurement, the fourth measurement, the fifth measurement and the sixth measurement.

9. Method according to Claim 8, **characterised in that** the movable unit (106.2) is moved in the third measurement step (110.4) according to the same scheme as in the first measurement step (110.2) and/or the second measurement step (110.3).

10. Method according to Claims 8 or 9, **characterised in that**
- in the first measurement step (110.2), the reference element (107.5) has a first position and a first orientation with respect to the movable unit (106.2) and
- before the second measurement step (110.3), the reference element (107.5) is moved into a pre-definable second position with respect to the movable unit (106.2) and, before the third measurement step (110.4), the reference element (107.5) is moved into a pre-definable third orientation with respect to the movable unit (106.2), wherein
- the first position and the second position are different from each other and the first orientation and the third orientation are different from each other,
or
- before the second measurement step (110.3), the reference element (107.5) is moved into a pre-definable second orientation with respect to the movable unit (106.2) and, before the third measurement step (110.4), the reference element (107.5) is moved into a pre-definable third position with respect to the movable unit (106.2), wherein
- the first position and the third position are different from each other and the first orientation and the second orientation are different from each other.

11. Method according to any one of Claims 4 to 10, **characterised in that**
- the calibration step (110.5) is a first calibration step and at least the result of the second measurement and the result of the fourth measurement are evaluated to eliminate a systematic error of the encoder system (107.3) and the result of the evaluation is stored in a reference dataset and
- in a fourth measurement step (110.2; 110.3; 110.4) following the first calibration step (110.5), the movable unit (106.2) is moved according to a pre-definable scheme in the at least one degree of freedom and a position of the movable unit (106.2) is captured in the at least one degree of freedom, wherein
- in a seventh measurement, the position of the movable unit (106.2) is captured in the at least one degree of freedom via the first measuring device (107.1),
- in an eighth measurement, the position of the movable unit is captured in the at least one degree of freedom via the second measuring device (107.3) using the reference element and
- in a second calibration step (110.5), the first measuring device (107.1) is calibrated using the reference dataset and the results of the seventh measurement and the eighth measurement.

12. Method according to any one of Claims 1 to 11, **characterised in that**
- the movable unit (106.2) defines a useful region, the position of the useful region being determined via the first measuring device (107.1) in normal operation of the optical device (101), and
- at least in the second measurement, the second measuring device (107.3) determines a measuring region of the reference element (107.5), wherein
- the measuring region is arranged at least close to the useful region.

13. Method according to any one of Claims 1 to 12, **characterised in that**
- the optical device (101) defines a working region in which the movable unit (106.2) is moved in normal operation of the optical device (101), and
- in the measurement step (110.2), the movable unit (106.2) is moved in the at least one degree of freedom at least over a large part of the working region.

14. Method according to any one of Claims 1 to 13, **characterised in that** at least during the second measurement, at least one reference mark of the reference element (107.5) is captured by the second measuring device (107.3).

15. Method according to any one of Claims 1 to 14, **characterised in that** it is used for calibrating a position measuring device for a mask table (104.2) of a microlithography device (101), for calibrating a position measuring device (107) for a substrate table (106.2) of a microlithography device (101), for calibrating a position measuring device for a substrate table of a substrate inspection device or for calibrating a position measuring device for a mask table of a mask inspection device.

16. Optical device, in particular for microlithography, having
- a movable unit (106.2) which can be moved by a drive unit,
- a control device (108) and
- a position measuring device (107), wherein
- the position measuring device (107) comprises a first measuring device (107.1) and a second measuring device (107.3),
- the position measuring device (107) is configured to capture, in a measurement step, a position of the movable unit (106.2), moved by the drive unit according to a pre-definable scheme, in at least one degree of freedom,
- the first measuring device (107.1) is configured to capture, in a first measurement, a first variable which is representative of the position of the movable unit (106.2) in the at least one degree of freedom and to pass it to the control device (108),
- the second measuring device (107.3) comprises a reference element (107.5) which is connected to the movable unit (106.2) and is configured to capture, in a second measurement, using the reference element (107.5), a second variable which is representative of the position of the movable unit (106.2) in the at least one degree of freedom and to pass it to the control device (108), and
- the control device (108) is configured to calibrate, in a calibration step, the first measuring device (107.1) using the results of the first measurement and the second measurement,
**characterised in that**
- the second measuring device comprises an encoder system (107.3), wherein
- the reference element (107.5) comprises a reference grid of the encoder system (107.3).

17. Optical device according to Claim 16, **characterised in that**
- the encoder system (107.3) is a two-dimensional encoder system with a two-dimensional reference grid
and/or
- the encoder system (107.3) is a high-resolution encoder system with a resolution below one nanometre.

18. Optical device according to Claim 16 or 17, **characterised in that**
- the reference element (107.5) has a low coefficient of thermal expansion and/or
- a thermal stabilisation device is provided, which is configured to thermally stabilise the reference element (107.5).

19. Optical device according to any one of Claims 16 to 18, **characterised in that**
- the measurement step is a first measurement step,
- the positioning device (107) is configured to capture, at least in a second measurement step, a position of the movable unit (106.2), moved by the drive unit according to a pre-definable scheme, in at least one degree of freedom,
- the first measuring device (107.1) is configured to capture, in a third measurement, a first variable which is representative of the position of the movable unit (106.2) in the at least one degree of freedom and to pass it to the control device (108),
- the second measuring device (107.3) is configured to capture, in a fourth measurement, using the reference element (107.5), a second variable which is representative of the position of the movable unit (106.2) in the at least one degree of freedom and to pass it to the control device (108), and
- the control device (108) is configured to calibrate, in the calibration step, the first measuring device (107.1) using the results of the first measurement, the second measurement, the third measurement and the fourth measurement.

20. Optical device according to Claim 19, **characterised in that**
- in the first measurement step, the reference element (107.5) has a first position and a first orientation with respect to the movable unit (106.2) and
- a manipulation device is provided which is configured to move the reference element (107.5), before the second measurement step, into a pre-definable second position and/or a pre-definable second orientation with respect to the movable unit (106.2), wherein
- the first position is different from the second position, and/or the first orientation is different from the second orientation.

21. Optical device according to Claim 19 or 20, **characterised in that**
- the second measuring device (107.3) comprises a first measuring unit (107.4) and a second measuring unit (107.6), wherein
- the first measuring unit (107.4) is configured to capture, for the second measurement, a variable which is representative of the position of the movable unit (106.2) in the at least one degree of freedom, and
- the second measuring unit (107.6) is configured to capture, for the fourth measurement, a variable which is representative of the position of the movable unit (106.2) in the at least one degree of freedom, wherein
- relative to the first measuring unit (107.4), the second measuring unit (107.6) is arranged displaced transversely with respect to the direction along the at least one degree of freedom,
- wherein the first measuring unit (107.4) and the second measuring unit (107.6), in particular, are arranged on a common, in particular thermally stabilised, support element (109).

22. Optical device according to Claim 20 or 21, **characterised in that**
- the calibration step is a first calibration step and the control device (108) is configured to evaluate at least the result of the second measurement and the result of the fourth measurement to eliminate a systematic error of the encoder system (107.3) and to store the result of the evaluation in a reference dataset and
- the position measuring device (107) is configured to capture, at least in one further measurement step following the first calibration step, in the at least one degree of freedom, a position of the movable unit (106.2) moved according to a pre-definable scheme in the at least one degree of freedom, wherein
- the first measuring device (107.1) is configured to capture, in a seventh measurement, a first variable which is representative of the position of the movable unit (106.2) in the at least one degree of freedom and to pass it on to the control device (108),
- the second measuring device (107.3) is configured to capture, in an eighth measurement, using the reference element (107.5), a second variable which is - representative of the position of the movable unit (106.2) in the at least one degree of freedom and to pass it to the control device (108), and
- the control device (108) is configured to calibrate, in a second calibration step, the first measuring device (107.1) using the reference dataset and the results of the seventh measurement and the eighth measurement.

23. Optical device according to any one of Claims 16 to 22, **characterised in that**
- the movable unit (106.2) defines a useful region, the position of the useful region being captured via the first measuring device (107.1) in normal operation of the optical device, and at least in the second measurement, the second measuring device (107.3) captures a measuring region of the reference element (107.5), wherein the measuring region is arranged at least close to the useful region.
and/or
- the optical device (101) defines a working region in which the movable unit (106.2) is moved in normal operation of the optical device (101) and the drive unit is configured to move the movable unit (106.2), in the measurement step, in the at least one degree of freedom at least over a large part of the working region.

24. Optical device according to any one of Claims 16 to 23, **characterised in that** the second measuring device (107.3) is configured to capture, at least during the second measurement, at least one reference mark of the reference element (107.5).

25. Optical device according to any one of Claims 16 to 24, **characterised in that** the position measuring device (107) is a position measuring device for a mask table (104.2) of a microlithography device (101), a position measuring device for a substrate table (106.2) of a microlithography device (101), a position measuring device for a substrate table of a substrate inspection device or a position measuring device for a mask table of a mask inspection device.

## Revendications

1. Procédé d'étalonnage d'un dispositif de mesure de positionnement (107) d'un dispositif optique (100), dans lequel
- dans une étape de mesure (110.2), une unité mobile (106.2) du dispositif optique (101) est déplacée selon un schéma prédéfinissable dans au moins un degré de liberté et une position de l'unité mobile (106.2) est enregistrée dans l'au moins un degré de liberté, où
- la position de l'unité mobile (106.2) est enregistrée dans l'au moins un degré de liberté dans une première mesure par le biais d'un premier dispositif de mesure (107.1) du dispositif de mesure de position (107) et
- la position de l'unité mobile (106.2) est déterminée dans l'au moins un degré de liberté dans une seconde mesure par le biais d'un second dispositif de mesure (107.3) du dispositif de mesure de position (107) en utilisant un élément de référence (107.5) connecté à l'unité mobile (106.2) et
- dans une étape d'étalonnage (110.5), le premier dispositif de mesure (107.1) est étalonné en utilisant les résultats de la première mesure et de la seconde mesure,
**caractérisé en ce que**
- un système d'encodeur est utilisé comme second dispositif de mesure (107.3), où
- l'élément de référence (107.5) comprend un réseau de référence du système d'encodeur (107.3).

2. Procédé selon la Revendication 1, **caractérisé en ce que**
- un système d'encodeur bidimensionnel est utilisé comme système d'encodeur (107.3), où un réseau bidimensionnel est utilisée comme réseau de référence,
et/ou
- un système d'encodeur à haute résolution est utilisé comme système d'encodeur (107.3), dont la résolution est en dessous d'un nanomètre.

3. Procédé selon la Revendication 1 ou 2, **caractérisé en ce que**
- un élément ayant un faible coefficient de dilatation thermique est utilisé comme élément de référence (107.5)
et/ou
- l'élément de référence (107.5) est stabilisé thermiquement par le biais d'un dispositif de stabilisation thermique.

4. Procédé selon une quelconque des Revendications 1 à 3, **caractérisé en ce que**
- l'étape de mesure (110.2) est une première étape de mesure et
- dans une seconde étape de mesure (110.3), l'unité mobile (106.2) est déplacée selon un schéma prédéfinissable dans l'au moins un degré de liberté et une position de l'unité mobile (106.2) est enregistrée dans l'au moins un degré de liberté, où
- dans une troisième mesure, la position de l'unité mobile (106.2) est déterminée dans l'au moins un degré de liberté par le biais du premier dispositif de mesure (107.1),
- dans une quatrième mesure, la position de l'unité mobile (106.2) est déterminée dans l'au moins un degré de liberté par le biais du second dispositif de mesure (107.3) en utilisant l'élément de référence (107.5) et
- dans l'étape d'étalonnage (110.5), le premier dispositif de mesure (107.1) est étalonné en utilisant les résultats de la première mesure, de la seconde mesure, de la troisième mesure et de la quatrième mesure.

5. Procédé selon la Revendication 4, **caractérisé en ce que** l'unité mobile (106.2) est déplacée dans la seconde étape de mesure (110.3) selon le même schéma que dans la première étape de mesure (110.2).

6. Procédé selon la Revendication 4 ou 5, **caractérisé en ce que**
- dans la première étape de mesure (110.2), l'élément de référence (107.5) a une première position et une première orientation par rapport à l'unité mobile (106.2) et
- avant la seconde étape de mesure (110.3), l'élément de référence (107.5) est déplacé dans une seconde position prédéfinissable et/ou une seconde orientation prédéfinissable par rapport à l'unité mobile (106.2), où
- la première position est différente de la seconde position, et/ou la première orientation est différente de la seconde orientation.

7. Procédé selon une quelconque des Revendications 4 à 6, **caractérisé en ce que**
- pour la seconde mesure, la position de l'unité mobile (106.2) est déterminée dans l'au moins un degré de liberté en utilisant une première unité de mesure (107.4) du second dispositif de mesure (107.3) et
- pour la quatrième mesure, la position de l'unité mobile (106.2) est déterminée dans l'au moins un degré de liberté en utilisant une seconde unité de mesure (107.6) du second dispositif de mesure (107.3), où
- en relation à la première unité de mesure (107.4), la seconde unité de mesure (107.6) est déplacée transversalement par rapport à la direction le long du au moins un degré de liberté.

8. Procédé selon une quelconque des Revendications 4 à 7, **caractérisé en ce que**
- dans une troisième étape de mesure (110.4), l'unité mobile (106.2) est déplacée selon un schéma prédéfinissable dans l'au moins un degré de liberté et une position de l'unité mobile (106.2) est enregistrée dans l'au moins un degré de liberté, où
- dans une cinquième mesure, la position d'une unité mobile (106.2) du dispositif optique (101) est enregistrée dans l'au moins un degré de liberté par le biais du premier dispositif de mesure (107.1),
- dans une sixième mesure, la position de l'unité mobile (106.2) est enregistrée dans l'au moins un degré de liberté par le biais du second dispositif de mesure (107.3) en utilisant l'élément de référence (107.5) et
- dans l'étape d'étalonnage (110.5), le premier dispositif de mesure (107.1) est étalonné en utilisant les résultats de la première mesure, de la seconde mesure, de la troisième mesure, de la quatrième mesure, de la cinquième mesure et de la sixième mesure.

9. Procédé selon la Revendication 8, **caractérisé en ce que** l'unité mobile (106.2) est déplacée dans la troisième étape de mesure (110.4) selon le même schéma que dans la première étape de mesure (110.2), et/ou la seconde étape de mesure (110.3).

10. Procédé selon la Revendication 8 ou 9, **caractérisé en ce que**
- dans la première étape de mesure (110.2), l'élément de référence (107.5) a une première position et une première orientation par rapport à l'unité mobile (106.2) et
- avant la seconde étape de mesure (110.3), l'élément de référence (107.5) est déplacé dans une seconde position prédéfinissable par rapport à l'unité mobile (106.2) et, avant la troisième étape de mesure (110.4), l'élément de référence (107.5) est déplacé dans une troisième orientation prédéfinissable par rapport à l'unité mobile (106.2), où
- la première position et la seconde position sont différentes l'une de l'autre et la première orientation et la troisième orientation sont différentes l'une de l'autre,
ou
- avant la seconde étape de mesure (110.3), l'élément de référence (107.5) est déplacé dans une seconde orientation prédéfinissable par rapport à l'unité mobile (106.2) et, avant la troisième étape de mesure (110.4), l'élément de référence (107.5) est déplacé dans une troisième position prédéfinissable par rapport à l'unité mobile (106.2), où
- la première position et la troisième position sont différentes l'une de l'autre et la première orientation et la seconde orientation sont différentes l'une de l'autre.

11. Procédé selon une quelconque des Revendications 4 à 10, **caractérisé en ce que**
- l'étape d'étalonnage (110.5) est une première étape d'étalonnage, et au moins le résultat de la seconde mesure et le résultat de la quatrième mesure sont évalués afin d'éliminer une erreur systématique du système d'encodeur (107.3) et le résultat de l'évaluation est stocké dans un ensemble de données de référence et
- dans une quatrième étape de mesure (110.2 ; 110.3 ; 110.4) suivant la première étape d'étalonnage (110.5), l'unité mobile (106.2) est déplacée selon un schéma prédéfinissable dans l'au moins un degré de liberté et une position de l'unité mobile (106.2) est enregistrée dans l'au moins un degré de liberté, où
- dans une septième mesure, la position de l'unité mobile (106.2) est enregistrée dans l'au moins un degré de liberté par le biais du premier dispositif de mesure (107.1),
- dans une huitième mesure, la position de l'unité mobile est enregistrée dans l'au moins un degré de liberté par le biais du second dispositif de mesure (107.3) en utilisant l'élément de référence et
- dans une seconde étape d'étalonnage (110.5), le premier dispositif de mesure (107.1) est étalonné en utilisant l'ensemble de données de référence et les résultats de la septième mesure et de la huitième mesure.

12. Procédé selon une quelconque des Revendications 1 à 11, **caractérisé en ce que**
- l'unité mobile (106.2) définit une région utile, la position de la région utile étant déterminée par le biais du premier dispositif de mesure (107.1) lors du fonctionnement normal du dispositif optique (101), et
- au moins dans la seconde mesure, le second dispositif de mesure (107.3) détermine une région de mesure de l'élément de référence (107.5), où
- la région de mesure est disposée au moins à proximité de la région utile.

13. Procédé selon une quelconque des Revendications 1 à 12, **caractérisé en ce que**
- le dispositif optique (101) définit une région de travail dans laquelle l'unité mobile (106.2) est déplacée lors du fonctionnement normal du dispositif optique (101), et
- dans l'étape de mesure (110.2), l'unité mobile (106.2) est déplacée dans l'au moins un degré liberté au moins sur une grande partie de la région de travail.

14. Procédé selon une quelconque des Revendications 1 à 13, **caractérisé en ce qu'**au moins pendant la seconde mesure, au moins une marque de référence de l'élément de référence (107.5) est enregistrée par le second dispositif de mesure (107.3).

15. Procédé selon une quelconque des Revendications 1 à 14, **caractérisé en ce qu'**il est utilisé pour étalonner un dispositif de mesure de position pour une table de masque (104.2) d'un dispositif de microlithographie (101), pour étalonner un dispositif de mesure de position (107) pour une table de substrat (106.2) d'un dispositif de microlithographie (101), pour étalonner un dispositif de mesure de position pour une table de substrat d'un dispositif d'inspection de substrat ou pour étalonner un dispositif de mesure de position pour une table de masque d'un dispositif d'inspection de masque.

16. Dispositif optique, en particulier pour la microlithographie, ayant
- une unité mobile (106.2) qui peut être déplacée par une unité d'entraînement,
- un dispositif de commande (108) et
- un dispositif de mesure de position (107), où
- le dispositif de mesure de position (107) comprend un premier dispositif de mesure (107.1) et un second dispositif de mesure (107.3),
- le dispositif de mesure de position (107) est configuré pour enregistrer, dans une étape de mesure, une position de l'unité mobile (106.2), déplacée par l'unité d'entraînement selon un schéma prédéfinissable, dans au moins un degré de liberté,
- le premier dispositif de mesure (107.1) est configuré pour enregistrer, dans une première mesure, une première variable qui est représentative de la position de l'unité mobile (106.2) dans le ou les degrés de liberté et pour la transmettre au dispositif de commande (108),
- le second dispositif de mesure (107.3) comprend un élément de référence (107.5) qui est connecté à l'unité mobile (106.2) et est configuré pour enregistrer, dans une seconde mesure, en utilisant l'élément de référence (107.5), une seconde variable qui est représentative de la position de l'unité mobile (106.2) dans l'au moins un degré de liberté et pour la transmettre au dispositif de commande (108), et
- le dispositif de commande (108) est configuré pour étalonner, dans une étape d'étalonnage, le premier dispositif de mesure (107.1) en utilisant les résultats de la première mesure et de la seconde mesure,
**caractérisé en ce que**
- le second dispositif de mesure comprend un système d'encodeur (107.3), où
- l'élément de référence (107.5) comprend un réseau de référence du système d'encodeur (107.3).

17. Dispositif optique selon la Revendication 16, **caractérisé en ce que**
- le système d'encodeur (107.3) est un système d'encodeur bidimensionnel avec un réseau de référence bidimensionnel
et/ou
- le système d'encodeur (107.3) est un système d'encodeur à haute résolution avec une résolution en dessous d'un nanomètre.

18. Dispositif optique selon la Revendication 16 ou 17, **caractérisé en ce que**
- l'élément de référence (107.5) a un faible coefficient de dilatation thermique et/ou
- un dispositif de stabilisation thermique est prévu, lequel est configuré pour stabiliser thermiquement l'élément de référence (107.5).

19. Dispositif optique selon une quelconque des Revendications 16 à 18, **caractérisé en ce que**
- l'étape de mesure est une première étape de mesure,
- le dispositif de positionnement (107) est configuré pour enregistrer, au moins dans une seconde étape de mesure, une position de l'unité mobile (106.2), déplacée par l'unité d'entraînement selon un schéma prédéfinissable, dans au moins un degré de liberté,
- le premier dispositif de mesure (107.1) est configuré pour déterminer, dans une troisième mesure, une première variable qui est représentative de la position de l'unité mobile (106.2) dans l'au moins un degré de liberté et pour la transmettre au dispositif de commande (108),
- le second dispositif de mesure (107.3) est configuré pour enregistrer, dans une quatrième mesure, en utilisant l'élément de référence (107.5), une seconde variable qui est représentative de la position de l'unité mobile (106.2) dans l'au moins un degré de liberté et pour la transmettre au dispositif de commande (108), et
- le dispositif de commande (108) est configuré pour étalonner, dans l'étape d'étalonnage, le premier dispositif de mesure (107.1) en utilisant les résultats de la première mesure, de la seconde mesure, de la troisième mesure et de la quatrième mesure.

20. Dispositif optique selon la Revendication 19, **caractérisé en ce que**
- dans la première étape de mesure, l'élément de référence (107.5) a une première position et une première orientation par rapport à l'unité mobile (106.2) et
- un dispositif de manipulation est prévu lequel est configuré pour déplacer l'élément de référence (107.5), avant la seconde étape de mesure, dans une seconde position prédéfinissable et/ou une seconde orientation prédéfinissable par rapport à l'unité mobile (106.2), où
- la première position est différente de la seconde position, et/ou la première orientation est différente de la seconde orientation.

21. Dispositif optique selon la Revendication 19 ou 20, **caractérisé en ce que**
- le second dispositif de mesure (107.3) comprend une première unité de mesure (107.4) et une seconde unité de mesure (107.6), où
- la première unité de mesure (107.4) est configurée pour enregistrer, pour la seconde mesure, une variable qui est représentative de la position de l'unité mobile (106.2) dans l'au moins un degré de liberté, et
- la seconde unité de mesure (107.6) est configurée pour enregistrer, pour la quatrième mesure, une variable qui est représentative de la position de l'unité mobile (106.2) dans l'au moins un degré de liberté, où
- en relation à la première unité de mesure (107.4), la seconde unité de mesure (107.6) est décalée transversalement par rapport à la direction le long du au moins un degré de liberté,
- où la première unité de mesure (107.4) et la seconde unité de mesure (107.6) sont disposées, en particulier, sur un élément de support (109) commun, en particulier thermiquement stabilisé.

22. Dispositif optique selon la Revendication 20 ou 21, **caractérisé en ce que**
- l'étape d'étalonnage est une première étape d'étalonnage, et le dispositif de commande (108) est configuré pour évaluer au moins le résultat de la seconde mesure et le résultat de la quatrième mesure afin d'éliminer une erreur systématique du système d'encodeur (107.3) et pour stocker le résultat de l'évaluation dans un ensemble de données de référence et
- le dispositif de mesure de position (107) est configuré pour enregistrer, au moins dans une ultérieure étape de mesure suivant la première étape d'étalonnage, dans l'au moins un degré de liberté, une position de l'unité mobile (106.2) déplacée selon un schéma prédéfinissable dans l'au moins un degré de liberté, où
- le premier dispositif de mesure (107.1) est configuré pour enregistrer, dans une septième mesure, une première variable qui est représentative de la position de l'unité mobile (106.2) dans l'au moins un degré de liberté et pour la transmettre au dispositif de commande (108),
- le second dispositif de mesure (107.3) est configuré pour enregistrer, dans une huitième mesure, en utilisant l'élément de référence (107.5), une seconde variable qui est représentative de la position de l'unité mobile (106.2) dans l'au moins un degré de liberté et pour la transmettre au dispositif de commande (108), et
- le dispositif de commande (108) est configuré pour étalonner, dans une seconde étape d'étalonnage, le premier dispositif de mesure (107.1) en utilisant l'ensemble de données de référence et les résultats de la septième mesure et de la huitième mesure.

23. Dispositif optique selon une quelconque des Revendications 16 à 22, **caractérisé en ce que**
- l'unité mobile (106.2) définit une région utile, la position de la région utile étant enregistrée par le biais du premier dispositif de mesure (107.1) lors du fonctionnement normal du dispositif optique, et au moins dans la seconde mesure, le second dispositif de mesure (107.3) enregistre une région de mesure de l'élément de référence (107.5), où la région de mesure est disposée au moins à proximité de la région utile.
et/ou
- le dispositif optique (101) définit une région de travail dans laquelle l'unité mobile (106.2) est déplacée lors du fonctionnement normal du dispositif optique (101) et l'unité d'entraînement est configurée pour déplacer l'unité mobile (106.2), dans l'étape de mesure, dans l'au moins un degré de liberté au moins sur une grande partie de la région de travail.

24. Dispositif optique selon une quelconque des Revendications 16 à 23, **caractérisé en ce que** le second dispositif de mesure (107.3) est configuré pour enregistrer, au moins pendant la seconde mesure, au moins une marque de référence de l'élément de référence (107.5).

25. Dispositif optique selon une quelconque des Revendications 16 à 24, **caractérisé en ce que** le dispositif de mesure de position (107) est un dispositif de mesure de position pour une table de masque (104.2) d'un dispositif de microlithographie (101), un dispositif de mesure de position pour une table de substrat (106.2) d'un dispositif de microlithographie (101), un dispositif de mesure de position pour une table de substrat d'un dispositif d'inspection de substrat ou un dispositif de mesure de position pour une table de masque d'un dispositif d'inspection de masque.
